# FASCICULE DE BREVET EUROPEEN

(11) **EP 0 507 667 B1**
(45) Date de publication et mention de la délivrance du brevet: **18.08.1999**
(21) Numéro de dépôt: 92400892.3
(22) Date de dépôt: 31.03.1992
(51) Int. Cl.: C23C 16/48, H01J 61/70

(54) **Procédé de traitement photochimique d'un matériau utilisant une source de lumière à tubes à éclairs**
Verfahren zur photochemischen Materialbehandlung unter Verwendung von einer zylindrischen Blitz-Lampe als Lichtquelle
Process for photochemical treatment of a material using a tubular flashlamp as light source

(30) Priorité: 02.04.1991 FR 9103964
(43) Date de publication de la demande: 07.10.1992
(73) Titulaire: FRANCE TELECOM, 75015 Paris (FR)
(72) Inventeur: Flicstein, Jean, F-75003 Paris (FR); Nissim, Yves, F-75005 Paris (FR); Licoppe, Christian, F-75017 Paris (FR); Vitel, Yves, F-91600 Savigny Sur Orge (FR)
(74) Mandataire: Lhoste, Catherine

(56) Documents cités:
- WO-A-85/01115
- US-A- 4 702 936
- JOURNAL OF APPLIED PHYSICS vol. 64, no. 6, 15 Septembre 1988, NEW YORK, USA pages 3254 - 62; KAWASAKI ET AL.: 'study on the early stage of photchemical vapor deposition of amorphous silicon from disilane on a sio2 substrate'
- MATERIALS SCIENCE REPORTS vol. 2, no. 2, 1 Mai 1987, AMSTERDAM, THE NETHERLANDS pages 51 - 98; M. HANABUSA: 'photoinduced deposition of thin films'
- LASER UND OPTOELEKTRONIK vol. 22, no. 4, 1 Août 1990, STUTTGART, DE pages 55 - 59; U. KOGELSCHATZ ET AL.: 'new incoherent ultraviolet eximer sources for photolytic material deposition'
- APPLIED PHYSICS LETTERS vol. 36, no. 1, 1 Janvier 1980, NEW YORK, USA pages 73 - 76; JUH TZENG LUE: 'arc annealing of bf2+ implanted silicon by a short pulse flash lamp'
- JOURNAL OF APPLIED PHYSICS vol. 64, no. 5, 1 Septembre 1988, NEW YORK, USA pages 2380 - 2383; TAKASHI FUYUKI ET AL.: 'deposition of high quality a-si:h by direct photodecomposition of si2h6 using vacuum ultraviolet light'
- INSTRUMENTS & EXPERIMENTAL TECHNIQUES vol. 29, no. 6, 1 Novembre 1986, NEW YORK, USA pages 1239 - 1266; YU. G. BASOV: 'flashlamp pumping systems for dye lasers (review)'
- INSTRUMENTS & EXPERIMENTAL TECHNIQUES vol. 18, no. 2, 1 Janvier 1975, NEW YORK, USA pages 219 - 220; YA.YA.KRYMSKII ET AL.: 'a coaxial lanp for flash photolysis'
- THE REVIEW OF SCIENTIFIC INSTRUMENTS vol. 38, no. 1, 1 Janvier 1967, NEW YORK pages 68 - 72; D. PERLMAN: 'MAXIMUM RATINGS FOR XENON FILLED LINEAR FLASHLAMPS'

## Description

La présente invention a pour objet un procédé de traitement photochimique d'un matériau. Une source de lumière à tubes à éclairs pour la mise en oeuvre de ce procédé est également décrite.

L'invention s'applique à tout type de matériau diélectrique, métallique ou semi-conducteur utilisé dans le domaine de la microélectronique, de l'optique intégrée, et dans tout autre domaine industriel nécessitant le dépôt de couches minces ou épaisses, le recuit de ces couches, une modification chimique de surface ou encore le nettoyage d'un substrat.

Ce procédé de traitement est qualifié de "doux" dans la mesure ou il utilise des énergies ou des températures en-dessous de celles de dégradation des surfaces. Ces notions seront précisées ultérieurement.

Plus spécialement, l'invention a pour objet le dépôt de matériaux céramiques et diélectriques. L'amélioration de la qualité de ces matériaux a permis leur utilisation sous forme de couches minces ou épaisses tant sur des substrats semiconducteurs que sur des substrats métalliques pour des applications très variées, en particulier grâce à des performances accrues de leurs propriétés électroniques, de leurs propriétés de gravure et de leur tenue mécanique (résistance à l'usure et corrosion).

Les dépôts de céramiques et de diélectriques confèrent aux surfaces des matériaux des propriétés très différentes de celles du matériau massif utilisé comme substrat. Par exemple, on peut allier la faible densité des alliages d'aluminium (matériau massif) à la dureté très supérieure des surfaces revêtues d'un dépôt de céramique.

L'épaisseur du dépôt varie d'une application à l'autre. Un dépôt utilisé pour ses propriétés mécaniques est un dépôt épais. Si le dépôt est utilisé pour ses propriétés de surface (réflectivité, résistivité, activité catalytique, etc.), il s'agit d'un dépôt mince.

Le développement des circuits intégrés (IC) en microélectronique et microoptoélectronique (OEIC) s'achemine actuellement vers un accroîssement de la densité d'intégration. Cet accroîssement permettra d'intégrer des fonctions de plus en plus complexes dans des dimensions toujours plus petites. Cette évolution impose donc une miniaturisation des composants élémentaires. Les procédés technologiques conventionnels peuvent alors se montrer insuffisants pour atteindre les objectifs de miniaturation fixés. De nouvelles techniques sont alors nécessaires afin de maîtriser des dépôts ultraminces.

Les principales techniques de dépôt de couches minces utilisées sont le dépôt par pulvérisation, le dépôt par canon à électrons, le dépôt chimique en phase vapeur (CVD), le dépôt CVD assisté par plasma (PECVD), le dépôt CVD induit par irradiation ultraviolette (UVCVD), le dépôt CVD assisté par thermie rapide ou irradiation infrarouge (RTCVD) et le dépôt par jet moléculaire (EJM).

Dans la mesure où l'un des buts de l'invention est de réaliser des dépôts CVD "doux" à basse température, on élimine de la présentation de l'état actuel des connaissances les techniques de dépôt plus "violentes" telles que la pulvérisation, le canon à électrons, le dépôt par jet moléculaire et le dépôt assisté par plasma comme par exemple le dépôt par décharge dans les gaz.

Le procédé de dépôt chimique en phase gazeuse est connu depuis la fin du siècle dernier, mais depuis une trentaine d'années, il connaît un grand développement dans le domaine des semi-conducteurs et de la protection de métaux contre l'usure et la corrosion.

La technique classique de CVD consiste à provoquer une réaction chimique entre les gaz précurseurs du dépôt et la surface du substrat. La réaction chimique est activée thermiquement par chauffage du substrat.

Les précurseurs sont soit des composés volatils, soit des composés ayant une pression de vapeur suffisante. Le mélange gazeux précurseurs-gaz porteur arrive dans le réacteur de dépôt, à une pression contrôlée comprise entre la pression atmosphérique et une fraction de la pression atmosphérique. Le substrat est maintenu à chaud, entre 400 et 1400°C, à l'aide d'un four régulé en température. Par suite d'effets catalytiques de surface, un dépôt solide se forme progressivement à la surface du substrat. Ce dépôt est créé par germination et croissance.

Selon la température de chauffage du substrat, la sursaturation des gaz et leurs vitesses, il peut se créer une microstructure différente d'un dépôt solide à l'autre. De plus, à basse température, l'accroîssement de la sursaturation engendre sur le substrat un dépôt pulvérulent ou même amorphe alors qu'à plus haute température, on obtient soit une couche cristalline ou polycristalline, soit une couche à texture cristalline colonnaire, soit des whiskers.

La notion "basse température" varie d'un substrat à l'autre et d'une couche à l'autre. La gamme "basse température" s'étend typiquement de la température ambiante à environ 350°C.

Les procédés connus de dépôt CVD présentent un certain nombre d'avantages comme la pureté et la compacité des couches, une très bonne adhérence au substrat, un pouvoir de recouvrement important, une uniformité en épaisseur pour des substrats de grande surface avec des motifs de formes complexes et un dépôt avec modification continue ou discontinue de la composition.

L'utilisation de composés organométalliques comme précurseurs gazeux (OMCVD) permet en outre un abaissement de la température de dépôt.

Ce procédé très largement employé présente malheureusement les inconvénients ci-après :
- processus long (le chauffage, le dépôt et le refroidissement exigent des procédés dont la durée est de l'ordre d'une ou plusieurs heures) ;
- possibilité de provoquer des réactions secondaires (craquage thermique non sélectif) ;
- possibilité de contaminer des couches minces déposées si les gaz utilisés ne sont pas purs et si les parois chaudes du réacteur de dépôt dégazent ;
- nécessité de températures élevées qui ne sont donc pas toujours compatibles avec les matériaux notamment sous-jacents ou les étapes technologiques en cours ;
- création de défauts structuraux dans le substrat, du fait des différences d'élasticité entre la couche et le substrat ;
- dépôt sur la surface entière du substrat sans possibilité de localisation ;
- pureté du dépôt limitée par l'incorporation des résidus organiques si les précurseurs utilisés sont des composés organométalliques (OMCVD).

Dans les techniques de dépôt CVD induites ou assistées par lampes (LCVD), on irradie en continu ou en pulsé (laser à excimère), à l'aide d'une source lumineuse, la surface d'un substrat placé dans un réacteur contenant des gaz précurseurs et un gaz porteur. Le mélange gazeux utilisé est gardé le plus souvent à une pression inférieure à 1,3 kPa.

Suivant la longueur d'onde d'irradiation choisie et l'orientation du flux lumineux par rapport à la surface du substrat, les photons seront prioritairement absorbés :
- par le substrat quand le flux lumineux est perpendiculaire au substrat,
- par le précurseur quant le flux lumineux est parallèle au substrat.

Quand le flux lumineux est infrarouge (IR), il s'agit de CVD assisté par thermie rapide et son utilisation avantageuse dans le domaine des semiconducteurs III-V est déjà décrite dans de nombreux documents ; voir à cet effet les documents US-A-4 914 059 et FR-A-2 618 455.

Les dépôts assistés par lumière ultraviolette (UV) ont également été décrits dans de nombreuses publications comme par exemple dans les articles de R.V. Cvetanovic, J. Chem. Phys. 23, 1203, 1955, intitulé "Mercury Photosensitized Decomposition of Nitrous Oxide" ; de J.W. Peters, F.L. Gebhart and T.C. Hall, Solid. State Technol. 23, 121, 1980, intitulé "Low Temperature Photo-CVD Silicon Nitride : Properties and Applications".

JOURNAL OF APPLIED PHYSICS, vol. 64(6), 15/9/98, pages 3254-62, (Kawasaki et al.) décrit un procédé pour la photonucléation de silicium amorphe hydrogéné sur silice thermique. Les tout premiers stades de nucléation et leur cinétique sont analysés. L'auteur utilise une source flash de taille millimétrique.

US-A-4 702 936 (Maedea et al.) décrit le dépôt d'oxynitrure de silicium par photolyse en utilisant un mélange de SiH₄, N₂O et NH₃ et des lampes émettant à 184,9 et 254,9nm.

WO85/01115 est relatif à la fabrication d'une structure diélectrique à couches alternées SiO₂/TiO₂, déposées selon un procédé de dépôt photochimique en phase vapeur.

MATERIALS SCIENCE REPORTS, vol. 2, no. 2, 1987, pages 51-98, (Hanabusa) décrit le dépôt photochimique de couches minces en utilisant des précurseurs en phase vapeur.

LASER UND OPTOELEKTRONIK, vol. 22, no. 4, 1/8/1990, pages 55-59, (U. Kogelschatz et al) est relatif au dépôt local de palladium par photolyse sur un substrat d'alumine en utilisant un laser à excimer de xénon émettant dans l'ultraviolet.

Dans les dépôts assistés par lumière UV, l'éclairement ne provoque pratiquement pas d'élévation de température ; ainsi les dépôts sont réalisés dans une gamme de température allant de 100 à 300°C.

Si les photoréactions conduisant au dépôt de couches minces sont obtenues à l'aide d'un gaz catalyseur introduit dans les gaz réactifs ou de tout autre intermédiaire comme les photosensibilisateurs, on a un risque de contamination du dépôt.

On rappelle que la photosensibilisation est un processus de photolyse indirect de type multiphotonique à transfert d'énergie par l'intermédiaire de gaz précurseurs ou de photosensibilisateurs qui permettent d'atteindre l'absorption optique du précurseur à des longueurs d'onde inférieures au spectre d'émission des lampes connues.

Par ailleurs, on observe en général, soit des réactions incomplètes (présence de résidus et de sous-produits de décomposition dans les couches), soit des vitesses de dépôt trop lentes pour présenter un intéret industriel lorsque les photoréactions sont induites directement (sans catalyseur ou photosensibilisateur).

Aussi, les films minces déposés à température ambiante sous irradiation ultraviolette sont inexploitables du fait de leur microstructure agrégative. Il est alors nécessaire de les recuire à des températures pas toujours compatibles avec les matériaux sous-jacents ou les étapes technologiques en cours.

Aussi, l'invention a notamment pour objet un procédé de dépôt photochimique du type CVD d'un matériau permettant de remédier en particulier aux inconvénients mentionnés ci-dessus. Ce procédé de dépôt utilise une source de lumière particulière.

Par ailleurs, l'utilisation de cette source de lumière permet d'avoir accès à de nouveaux procédés de traitement des matériaux généralement utilisés en microélectronique ou en optoélectronique. L'invention n'est donc pas limitée à un procédé de dépôt photochimique.

De façon plus précise l'invention a pour objet un procédé de traitement photochimique d'un matériau solide, consistant à exposer ce matériau à des impulsions lumineuses produites par au moins un tube allongé à gaz rare sous basse pression et à décharge luminescente dont le gaz, la pression et les caractéristiques de la décharge sont adaptés audit matériau et à ses précurseurs, chaque impulsion contenant un spectre d'émission étendu allant de 160 à 5000nm les précurseurs consistant en des gaz, des liquides ou des solides présents dans le matériau, sur le matériau et/ou dans un flux de gaz porteur. De plus, dans l'invention, on utilise un gaz rare atomique.

Pour la mise en oeuvre du procédé de l'invention, on utilise une source de lumière à tubes à éclairs émettant dans une gamme étendue de longueurs d'onde allant de l'ultraviolet profond (VUV) au proche infrarouge (NIR). En particulier, on choisit le gaz, sa pression et les caractéristiques de la lampe pour que le spectre présente des raies d'émission ionique dans l'ultraviolet, ces raies étant aptes à être absorbées par lesdits précurseurs et non par le matériau, et un continuum de spectre dans le visible et l'infrarouge.

On peut utiliser une source de lumière comportant a) - au moins un tube à décharge luminescente, ce tube comportant une enveloppe en verre transparent aux rayonnements de 160 à 5000nm, cette enveloppe étant fermée hermétiquement et renfermant un gaz rare sous basse pression, une anode et une cathode disposées en regard ; b) - un circuit électrique à caractéristiques électriques modulables pour la modulation des caractéristiques de décharge du tube et le stockage de l'énergie nécessaire à cette décharge, ce circuit comportant au moins un condensateur de capacité variable, connecté en parallèle avec le tube ; c) - une source d'alimentation électrique à courant constant, branchée aux bornes du condensateur pour le charger ; d) - un circuit excitateur pour initier une ionisation du gaz et une décharge du condensateur, la décharge du condensateur produisant une impulsion de courant entre l'anode et la cathode et, en conséquence, une impulsion lumineuse et e) - un générateur d'impulsions électriques haute tension pour commander l'excitateur.

La lampe utilisable dans l'invention, contrairement à celles utilisées classiquement dans les procédés photochimiques, présente des caractéristiques d'émission modulables tant en intensité lumineuse globale, qu'en durée des impulsions. L'intensité respective de chaque longueur d'onde est également modulable. Cette lampe présente une grande souplesse d'utilisation permettant non seulement d'améliorer les procédés de traitement et en particulier de dépôt de couches minces par photo-CVD connus mais encore la mise en oeuvre de nouveaux procédé de traitement photochimique.

La pondération de chaque domaine de longueurs d'onde (UV, visible, IR) est obtenue par le contrôle de la pression du gaz rare dans les tubes et de l'intensité du courant de la décharge qui varie de 1kA/cm² à 10kA/cm² environ. En particulier, pour un gaz rare donné et une énergie de décharge donnée, l'intensité lumineuse croît de l'UV profond au proche infrarouge lorsque la pression du gaz augmente.

Avantageusement, la gamme de pression du gaz dans le tube à éclairs est choisie entre 1,3kPa et 40kPa (10 à 300 torrs) ou mieux entre 6 et 27kPa (environ 50 à 200 torrs).

La durée de chaque éclair, la fréquence et leur intensité lumineuse sont ajustables séparément, ce qui confère à la lampe une grande souplesse d'utilisation. En particulier, chaque éclair a une durée de 1 à 200 µs et la fréquence de répétition des éclairs est de 1 à 5000 Hertz selon l'énergie de décharge du condensateur.

L'ajustement de la fréquence de répétition des éclairs, de la durée de chaque éclair et de l'intensité du courant est fonction de l'application spécifique envisagée. Cet ajustement, pour des durées de 30 µs, permet de rendre prépondérant l'un ou l'autre des domaines de longueurs d'onde. En particulier, l'infrarouge domine à faible courant permettant d'atteindre des fréquences supérieures à 30 Hz alors que l'ultraviolet domine à fort courant permettant d'atteindre des fréquences inférieures à 20 Hz.

Par ailleurs, plus l'énergie de charge du condensateur et donc plus l'intensité du courant délivré dans le tube augmentent, plus la contribution du rayonnement ultraviolet augmente.

Le procédé de l'invention est en particulier un procédé de dépôt en phase vapeur d'une couche mince ou épaisse d'un isolant, d'un métal, d'un semi-métal ou d'un semi-conducteur. Selon l'invention, ce procédé de dépôt consiste à exposer le substrat à des précurseurs sous forme gazeuse , solide ou liquide de la couche à déposer pendant l'exposition de ce même substrat aux impulsions lumineuses.

Ce procédé de dépôt présente par rapport aux procédés de dépôt CVD connus plusieurs améliorations. Ainsi, les processus de dépôt sont beaucoup plus courts grâce à l'efficacité du dépôt ultraviolet et au soutien des infrarouges. Les temps d'interaction tels que l'absorption lumineuse par le substrat, la photoréaction et l'évacuation des produits secondaires formés sont instantanés et donc ne ralentissent pas la réaction et ne contaminent pas les dépôts.

De plus, grâce à l'action conjointe de l'irradiation ultraviolette et de l'irradiation infrarouge, les problèmes de germination, des réactions secondaires et des contaminations des dépôts sont minimisés.

En outre, en irradiant localement le substrat en présence des précurseurs gazeux de la couche à déposer et en focalisant le flux lumineux, il est possible de réaliser un dépôt local, contrairement aux procédés connus de dépôt CVD.

Par ailleurs, selon l'invention, le dépôt des couches est réalisé à froid.

Dans un procédé de traitement dit à froid, la température maximale de chauffage du substrat dépend bien sur de la température que peut supporter la surface du substrat. En pratique, le substrat est porté à des températures choisies dans la gamme allant de la température ambiante à 350°C ; cette température est due à l'exposition du substrat aux impulsions lumineuses et non à un chauffage additionnel.

Le dépôt à froid permet de limiter les contaminations des couches déposées et d'utiliser des substrats jusqu'alors inutilisables du fait de leur mauvaise tenue en température (verre organométallique, polymère, etc.). De plus, le substrat n'est pas contraint.

Ces dépôts à froid sont réalisés avec des cinétiques importantes compatibles avec les procédés industriels. En particulier, la vitesse de dépôt est supérieure à celle obtenue par la technique classique UVCVD. Ainsi, des dépôts à une vitesse typiquement supérieure à 100 nm par minute peuvent être réalisés.

En outre, des dépôts de couches (minces ou épaisses) peuvent être obtenus pour des systèmes qui nécessitaient auparavant une photosensibilisation au mercure pour atteindre des taux de croissances compatibles avec les applications en microélectronique. En particulier, les mêmes taux de dépôts que ceux obtenus classiquement avec photosensibilisation ont été obtenus par les inventeurs, sans photosensibilisation au mercure, pour un dépôt de dioxyde de silicium à partir d'un mélange gazeux de silane et de protoxyde d'azote ou d'oxygène et pour un dépôt de nitrure de silicium à partir d'un mélange gazeux de silane et d'ammoniac.

De plus, cette technique de photosensibilisation, associée à la source lumineuse utilisable dans l'invention, peut donner accès à des dépôts qui ne sont pas possible jusqu'à ce jour avec l'emploi de la source lumineuse seule.

Avec le procédé de l'invention, il est possible aussi de déposer à froid une couche d'oxynitrure de silicium à partir d'un mélange de silane, de protoxyde d'azote et d'ammoniac.

Selon l'invention, il est aussi possible ce déposer des couches semiconductrices comme par exemple des couches de silicium à partir notamment du silane et de ses dérivés ; des couches de germanium à partir notamment du germane, et des couches de matériaux III-V et II-VI à partir d'organométalliques ainsi que des couches métalliques à partir de ces précurseurs organométalliques.

Selon l'invention, il est aussi possible de déposer in situ, en alternance, des couches de nature différente. En particulier, on peut envisager la réalisation d'un super-réseau avec le procédé de l'invention.

Dans ce cas, le procédé de l'invention consiste à
1) - soumettre le substrat à au moins un premier précurseur gazeux, liquide ou solide d'une première couche pendant que l'on expose le substrat auxdites impulsions lumineuses,
2) - soumettre le substrat à au moins un second précurseur gazeux, liquide ou solide d'une seconde couche pendant que l'on expose à nouveau le substrat auxdites impulsions lumineuses, et
3) - répéter successivement les étapes 1 et 2 jusqu'à obtenir un empilement de couches voulu.

Le procédé de traitement de l'invention peut aussi consister en la conversion d'un oxyde natif d'un matériau III-V en dioxyde de silicium. Ceci peut être intéressant pour la réalisation de structures MIS en matériau III-V. Pour ce faire, on soumet le matériau III-V à du silane pendant qu'on l'expose aux impulsions lumineuses de la lampe. Le dioxyde de silicium obtenu est stable et permet une amélioration des performances électroniques du matériau III-V.

Dans ce procédé de conversion, le rayonnement ultraviolet induit un mécanisme spécifique de réduction des oxydes par le silane où le silicium est incorporé avec des liaisons hydrogène, au contraire du processus pur thermique qui n'implique pas d'états intermédiaires hydrogénés. La contribution concomitante du rayonnement infrarouge émis stimule l'évacuation des produits secondaires.

Le procédé de l'invention peut en outre consister en un traitement à froid de couches déposées à température ambiante par CVD sous irradiation ultraviolette. En effet, les couches déposées à température ambiante selon l'art antérieur présentent une microstructure désordonnée. Aussi, le traitement de ces couches à température ambiante avec la lampe de l'invention permet de rendre plus compacts les dépôts et de guérir en outre certains défauts chimiques de ces dépôts. Ainsi, ce traitement est équivalent à celui d'un traitement thermique réalisé à haute température.

Grâce à l'invention, il est maintenant possible de déposer des couches minces diélectriques et céramiques, utilisables pour des composants microélectroniques en maintenant le substrat à température ambiante et sans effectuer de recuit thermique.

Le procédé de l'invention peut en outre consister en un nettoyage à froid de surface. En effet, grâce à l'étendue spectrale et à l'émission dans la région ultraviolette, l'irradiation d'un substrat permet d'exciter électroniquement (prédissocier ou dissocier) des molécules adsorbées ; de façon concomitante, la contribution infrarouge permet une désorption de fragments créés par dissociation et donc un nettoyage des surfaces. Ce nettoyage peut être effectué en l'absence ou la présence d'un gaz de nettoyage.

Cet effet a été observé en laboratoire sur les liaisons hydroxyle et hydrogène à la surface de semiconducteurs III-V et de couches isolantes de dioxyde de silicium et de nitrure de silicium.

Ce nettoyage à froid peut aussi être réalisé sur des matériaux métalliques.

Avec la diversité des procédés décrits et la lampe utilisable dans l'invention, l'intégration des étapes de réalisation photo-assistées d'un composant in situ est maintenant envisageable.

D'autres caractéristiques et avantages de l'invention ressortiront mieux de la description qui va suivre, donnée à titre illustratif et non limitatif, en référence aux dessins annexés, dans lesquels :
- les figures 1a et 1b représentent schématiquement une lampe à tubes à éclairs pour la mise en oeuvre du procédé de l'invention ;
- la figure 2 donne le pourcentage de transmission du verre constituant les tubes en fonction de la longueur d'onde ;
- la figure 3 donne l'évolution du courant (I) exprimé en ampères en fonction de l'énergie de décharge (E) exprimée en joules du condensateur dans le cas d'un tube rempli de krypton sous 13,3 kPa ;
- la figure 4 représente la luminance spectrale (Lλ) exprimée en watt/(cm².cm.sr) entre 175 et 200 nm, obtenue au maximum du courant de décharge pour des tubes remplis respectivement d'argon, de xénon et de krypton ;
- la figure 5 représente l'évolution de la luminance spectrale (Lλ) exprimée en W/(cm².cm.sr) entre 175 et 200 nm d'un tube rempli de krypton sous 13,3 kPa pour trois énergies de décharge : les spectres A, B et C correspondent respectivement à des énergies de décharge de 45 J, 24 J et 16 J ;
- la figure 6 donne les variations de la luminance maximale (L), dans l'intervalle spectral 175-200 nm, exprimée en W/(cm².sr) en fonction de l'énergie de décharge (E) exprimée en Joules pour un tube rempli de krypton à 13,3 kPa ;
- la figure 7 montre l'évolution relative de la luminance spectrale (L) en fonction de la longueur d'onde exprimée en nanomètre pour différentes énergies de décharge d'un tube rempli de krypton à 13,3 kPa ;
- la figure 8 donne le rapport des spectres de la figure 7 en fonction de la longueur d'onde exprimée en nanomètre pour les deux énergies de décharges respectivement à 45 J et 12,8 J ;
- la figure 9 illustre schématiquement le procédé de traitement conforme à l'invention ;
- la figure 10 donne l'évolution du spectre infrarouge à séries de Fourier pour une couche de SiO₂ déposée selon l'invention (courbe d) puis traitée selon l'invention (courbe e) ;
- la figure 11 donne l'évolution du spectre infrarouge à séries de Fourier pour des couches de SiO₂ déposées par photolyse avec une lampe à mercure, traitées selon l'invention (courbes i et j) et irradiées par une lampe à mercure (courbes g et h), et
- la figure 12 donne les variations de la capacité d'un condensateur, pourvu d'une couche de SiO₂ déposée et traitée selon l'invention, en fonction de la tension U_{c} appliquée à ses bornes.

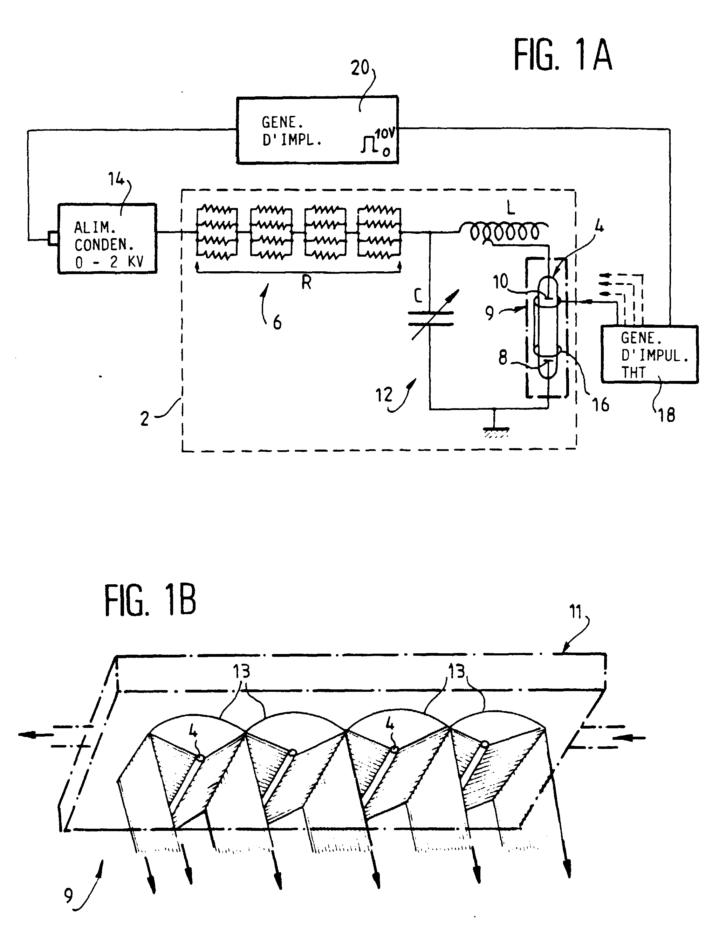

En référence aux figures 1a et 1b, on décrit ci-après la lampe à éclairs permettant la mise en oeuvre du procédé conforme à l'invention. Cette lampe comporte plusieurs ensembles 2 constitués chacun essentiellement d'un tube à éclairs ou à décharges lumineuses 4 et d'un circuit électrique 6 de modulation et d'adaptation de la décharge luminescente du tube à éclairs 4. En pratique, on utilisera 4 ensembles 2 afin d'obtenir un éclairement optimum ainsi qu'une homogénéité d'éclairement sur des matériaux de surface importante à traiter. Pour des raisons de simplification de la figure 1a, on a représenté qu'un seul ensemble 2.

Les tubes à éclairs 4 peuvent avoir n'importe quelle forme (cylindrique, spiralée ou autre), avec une longueur très supérieure à son ou ses diamètre(s). Sur la figure 1, on a représenté à titre d'exemple des tubes linéaires à enveloppe cylindrique en silice synthétique de très haute pureté présentant une fenêtre de transmission allant de 160 à 5000 nm. En particulier, ces tubes sont réalisés en SUPRASIL I, II^{(R)} commercialisé par la Société HERAEUS.

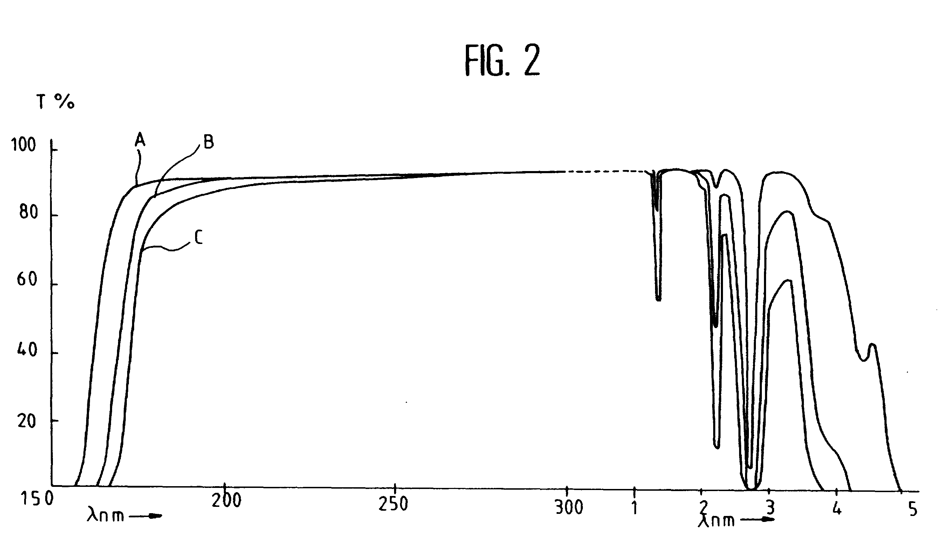

Le coefficient de transmission de cette silice synthétique en fonction de la longueur d'onde est représenté sur la figure 2. Les spectres A, B et C correspondent respectivement à une épaisseur de silice de 1mm, 10mm et 30mm.

Ces enveloppes sont hermétiquement fermées et renferment un gaz rare sous basse pression ainsi qu'une anode 10 et une cathode 8 disposées en regard. Selon l'intensité lumineuse recherchée dans chaque gamme de longueurs d'onde, on utilisera comme gaz rare de l'argon, du krypton ou du xénon à des pressions de 1,3kPa à 40kPa (10 à 300 torrs) ou mieux de 6,6kPa à 27kPa (50 à 200 torrs).

En pratique on utilise des tubes qui dépassent de 1 à 2 cm la taille des échantillons à traiter. Par conséquent, la distance interélectrode est déterminée aussi par la taille de l'échantillon à traiter.

A titre d'exemple, on peut utiliser en pratique pour des échantillons de 100mm de diamètre, des tubes dont les dimensions sont : 8mm de diamètre interne, 220mm de long et une épaisseur de paroi de 1mm. La distance inter-électrodes est de 120mm et les électrodes sont à base de tungstène.

Un système de refroidissement 9 par convection forcée est prévu autour des tubes à éclairs 4. Ce système peut consister, comme représenté sur la figure 1b, en un boîtier en plastique rigide 11 contenant les tubes 4 dans lequel circule un flux de gaz inerte (azote par exemple) en surpression. Il permet, en plus du refroidissement, d'empêcher la formation d'ozone.

Afin d'obtenir un éclairage homogène et uniforme, des réflecteurs paraboliques 13 sont prévus en arrière des tubes ; un réflecteur par tube, orienté dans le sens longitudinal du tube avec le tube au foyer du réflecteur.

Ainsi, la lumière frappant le matériau à traiter résulte de la lumière émise directemant par les tubes et de la lumière réfléchie par les réflecteurs.

Le circuit électrique 6 associé à chaque tube 4 comporte un circuit LC 12 branché en parallèle entre l'anode et la cathode des tubes 4. Afin de modifier les caractéristiques de la décharge luminescente du tube 4 le condensateur C présente une capacité variable (par groupement de condensateurs) et la bobine L une inductance variable. Ce circuit LC assure le stockage de l'énergie électrique nécessaire à la décharge et la mise en forme de l'impulsion de cette décharge lumineuse.

Une source d'alimentation électrique à courant constant branchée aux bornes du condensateur C permet de le charger. La tension de charge de cette source 14 est ajustable de 0 à quelques kV.

L'utilisation d'une source à courant constant permet un meilleur contrôle de l'énergie emmagasinée par le condensateur et donc une meilleure reproductibilité d'un éclair à l'autre du fait que la montée en tension aux bornes du condensateur est linéaire en fonction du temps.

Un ensemble résistif de protection R est prévu entre la source 14 et le circuit LC afin d'éviter que la source 14 ne débite directement sur le court-circuit que représente le condensateur C non chargé.

Un circuit excitateur 16 constitué d'un fil conducteur entoure chaque tube 4 le long de l'une de ses génératrices. Ce circuit excitateur 16 sert à initier une ionisation du gaz contenu dans le tube ainsi que la décharge du condensateur. Ce circuit 16 est relié à un générateur d'impulsions à très haute tension 18.

Afin d'assurer la décharge du condensateur après sa charge, la sortie du générateur à très haute tension 18 est reliée à l'entrée de la source d'alimentation 14. Cette connexion entre le générateur 18 et la source d'alimentation 14 peut être assurée via un générateur d'impulsions basse tension 20 ; ce générateur 20 permet la synchronisation de la charge du générateur et de la décharge lumineuse.

La nécessité de ce générateur d'impulsions 20 dépend des caractéristiques de la source d'alimentation de charge 14 et plus précisément du délai qu'il y a entre le début de la décharge et de la reprise de la charge. Si ce délai est supérieur à la durée de l'éclair, le générateur 20 n'est pas nécessaire. Dans le cas contraire, on l'utilise pour inhiber cette remise en route et éviter que la source d'alimentation 14 ne débite dans un tube 4 en conduction.

On utilise par exemple un générateur d'impulsions THT fabriqué par la Société Hartley Measurements Limited, modèle 350, qui délivre une impulsion de 30 kV de 1µs de temps de montée à une fréquence pouvant varier de 1 à 100 Hz. Le générateur d'impulsions basse tension est fabriqué par la Société Tekelec-Airtronic sous la référence TE 10 ; ce générateur présente un réglage indépendant du retard et de la durée de l'impulsion dont les valeurs peuvent varier de 1µs à 1s. L'amplitude de la tension de sortie est ajustable de 1 à 10 volts sous 50 ohms. La source d'alimentation 14 est fabriquée par la Société ALE Systems et porte la référence 302 L 2KVP. La tension de charge est ajustable de 0 à 2kV, la puissance moyenne est de 4000 J/s et le courant de charge est de l'ordre de 4A.

En outre, l'ensemble de résistances R équivaut à une résistance de 47 ohms placée en série avec le circuit LC.

Pour un tube à éclairs donné 4, renfermant un gaz donné à une pression donnée, on choisit Les valeurs de la capacité du condensateur C et de l'inductance de la bobine L en fonction de la durée de la décharge souhaitée, qui est proportionnelle à (LC)^{1/2}, et pour obtenir une décharge du condensateur dans des conditions proches de l'amortissement critique, c'est-à-dire que (L/C)^{1/2} est de l'ordre de l'impédance de la colonne de plasma. Cette condition assure le meilleur transfert de l'énergie électrique en énergie lumineuse dans le tube 4.

La source d'alimentation 14 charge à courant quasi-constant le condensateur C jusqu'à la tension correspondant à l'énergie électrique prévue pour la décharge. Selon l'invention, la densité de courant de la décharge est de façon générale choisie entre 1kA/cm² et 10kA/cm².

Par exemple pour un condensateur de 40µF, on utilise des charges, suivant le tube choisi, entre 600 et 1800 volts, ce qui correspond à des énergies de décharge de 7,2 à 64,8 J. L'intensité maximale des courants de décharge varie dans une gamme comprise entre 580 et 2300 Ampères.

Une fois le condensateur chargé, le générateur d'impulsions THT 18 permet la rupture diélectrique du gaz contenu dans le tube 4 qui amorce la décharge lumineuse. La rupture diélectrique du gaz est assurée par le circuit 16. La fréquence de cette impulsion détermine la fréquence des éclairs. La limite haute de cette fréquence est imposée pour une énergie électrique donnée, soit par le temps de charge minimum dû à la source d'alimentation 14, soit par les conditions de refroidissement du tube 4 à éclairs.

Pour les tubes 4 décrits ci-dessus et les durées de décharge comprises entre 50 et 100 µs, la puissance moyenne des tubes ne doit pas dépasser 800 watts, en refroidissement par convection forcée.

Le générateur d'impulsions 20, synchronisé par l'impulsion THT de déclenchement, assure le blocage des thyristors de la source d'alimentation 14 durant la décharge et limite son rapport cyclique (temps de charge/temps entre charges) à moins de 90% pour les plus hautes fréquences (50 Hz). Sans ce blocage, l'alimentation se mettrait à débiter dans le tube en conduction et maintiendrait cet état jusqu'à son arrêt de sécurité lorsque la durée du courant de charge dépasse une certaine valeur (0,5 s).

A titre d'exemple, la gamme d'intensités lumineuses du tube dans la gamme spectrale de 175 à 200 nm est, de façon instantanée au maximum d'émission de la lampe, de 0,5 kW/sr à 20 kW/sr et en valeur moyenne pour un éclair par seconde de durée de 30 µs, à mi-hauteur, de 15 mW/sr à 600 mW/sr.

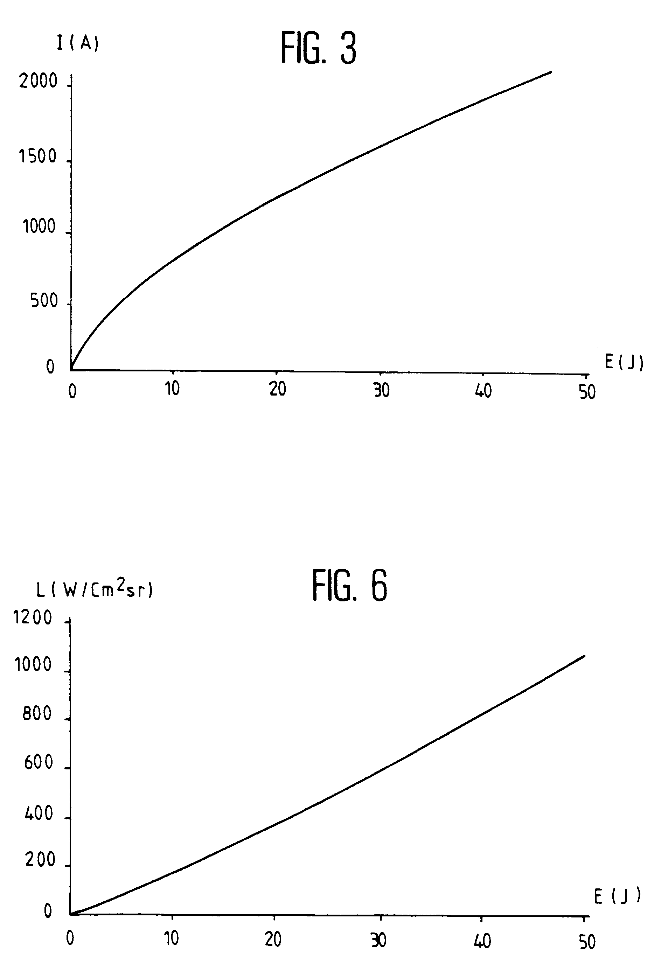

La figure 3 représente l'évolution du courant en fonction de l'énergie de décharge du condensateur dans le cas d'un tube rempli de krypton sous 13,3 kPa ; les durées à mi-hauteur de ces décharges sont de l'ordre de 30 µs. La plage de variations de cette durée en fonction de l'énergie est inférieure à 10%.

La lampe décrite ci-dessus possède une intensité lumineuse dans le domaine des UV profonds (VUV) particulièrement intense et notamment 100 fois plus intense que les lampes basse pression au mercure conventionnellement employées en photo-CVD.

Pour obtenir les conditions d'émission ci-dessus, on utilise de l'argon, du xénon ou de krypton à des pressions d'environ 1,3kPa à 40kPa et mieux de 6,6kPa à 27kPa. La limite basse pression dans les tubes est liée au fait que pour un courant de décharge élevé, la pulvérisation de la cathode est d'autant plus forte que la pression dans le tube est faible ce qui est néfaste pour la longévité des tubes. Pour une pression supérieure à la limite haute, l'intensité lumineuse des UV profonds est insuffisante pour effectuer le traitement.

De même, la durée de la décharge dans le tube à fort courant doit être suffisamment courte pour éviter les échanges thermiques plasma-paroi d'où le choix d'une gamme de fréquences de 1 à 50 Hz. Ces échanges thermiques conduisent à l'évaporation de la silice qui pollue le gaz d'origine produisant ainsi un abaissement de la température de plasma et donc une forte diminution de l'émission UV.

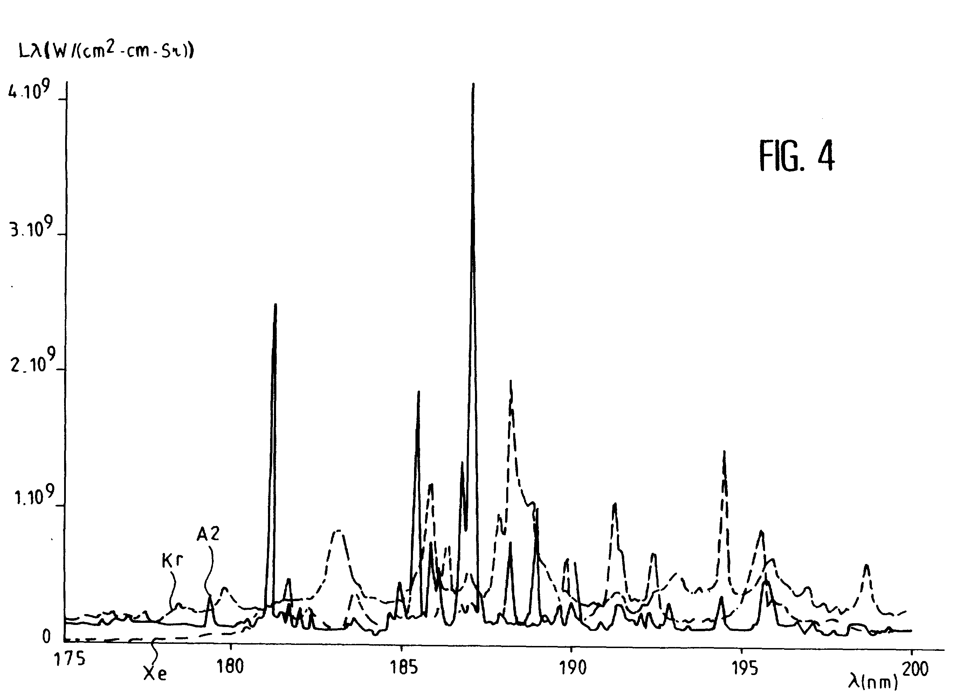

Sur la figure 4, on a représenté la luminance spectrale L, en fonction de la longueur d'onde obtenue au maximum du courant de décharge pour chaque tube. La courbe en trait continu correspond à l'émission d'un tube contenant de l'argon à 13,3 kPa pour une énergie de décharge de 36 J ; la courbe en tirets correspond au spectre d'émission d'un tube contenant du xénon à 13,3 kPa pour une énergie de charge de 51 J et la courbe en pointillés est le spectre d'émission d'un tube contenant du krypton à 13,3 kPa pour une énergie de charge de 45 J.

Le rayonnement des tubes dans le domaine de 175 à 200 nm (ultraviolet lointain) est constitué d'un continuum de recombinaisons sur lequel se superposent de fortes raies de l'atome une fois ionisé du gaz considéré. La répartition des raies spectrales et leur différente intensité permet de sélectionner le gaz le plus adapté à chaque processus photochimique utilisé.

Comparativement au tube à xénon utilisable dans l'invention, on observe une luminance spectrale instantanée plus élevée pour les tubes à l'argon, le maximum atteint étant de 4,4.10⁹W(cm².cm. ) et la luminance instantanée maximale étant de 570W/(cm².sr) pour le domaine spectral 175-200 nm. La valeur moyenne de la luminance, ramenée à une fréquence de tirs (éclairs) de 1Hz, est de 18mW/(cm².sr).

Cette différence entre les deux tubes s'explique par le fait que pour une densité de courant de décharge comparable, la température d'un plasma d'argon est plus élevée que celle d'un plasma de xénon, compte tenu du plus haut potentiel d'ionisation de l'argon. Ceci a pour conséquence de renforcer le spectre d'émission dans l'ultraviolet.

On peut également observer que, pour le tube d'argon, la contribution relative de la luminance due aux raies spectrales sur la luminance totale, est plus importante que dans le cas du tube à xénon.

On a reporté, dans le tableau ci-après, les valeurs des luminances maximales instantanées et moyennées à 1Hz mesurées pour ces deux tubes dans la bande spectrale 180-200nm. On a également reporté les valeurs de la luminance maximale et moyennée d'une lampe à vapeur de mercure connue, en forme de U, ayant la plus forte émission dans cet intervalle, et donc une raie de résonance à 185nm.

**TABLEAU I**

| Lampe | Luminance instantanée W/(cm².sr) | Luminance moyenne mW/(cm².sr) |
|---|---|---|
| Xénon 13,3kPa | 170 | 5,3 |
| Argon 13,3kPa | 570 | 18 |
| Mercure forme en U | 1,0.10⁻² | 6,3 |

On voit sur ce tableau I que les luminances instantanées émises par les tubes à éclairs sont considérablment plus fortes que celles des lampes à vapeur de mercure. La luminance moyenne des tubes utilisables dans l'invention dans le cas d'une fréquence de tirs de 1Hz est, pour le tube à xénon, du même ordre de grandeur que celle de la lampe à vapeur de mercure la plus intense, et pour le tube à argon de trois fois supérieure. D'autre part, la surface d'émission que présente le plasma dans les tubes à éclairs de l'invention est plus importante que celle de la colonne de plasma dans la lampe à mercure en U.

Aussi, l'intensité lumineuse moyenne émise par les tubes utilisables dans l'invention à 1Hz, dans la bande 180-200nm, est supérieure à celle des lampes à vapeur de mercure utilisées.

Des essais avec une lampe à argon sous une pression de 13,3 kPa ont montré que pour la plus forte énergie électrique de décharge, on observait une saturation de l'effet photochimique. Ainsi, pour chaque tube on choisit une gamme d'énergie de décharge qui permet d'adapter le flux de photons aux besoins de l'application et de faire varier la fréquence maximale des éclairs suivant l'énergie déposée.

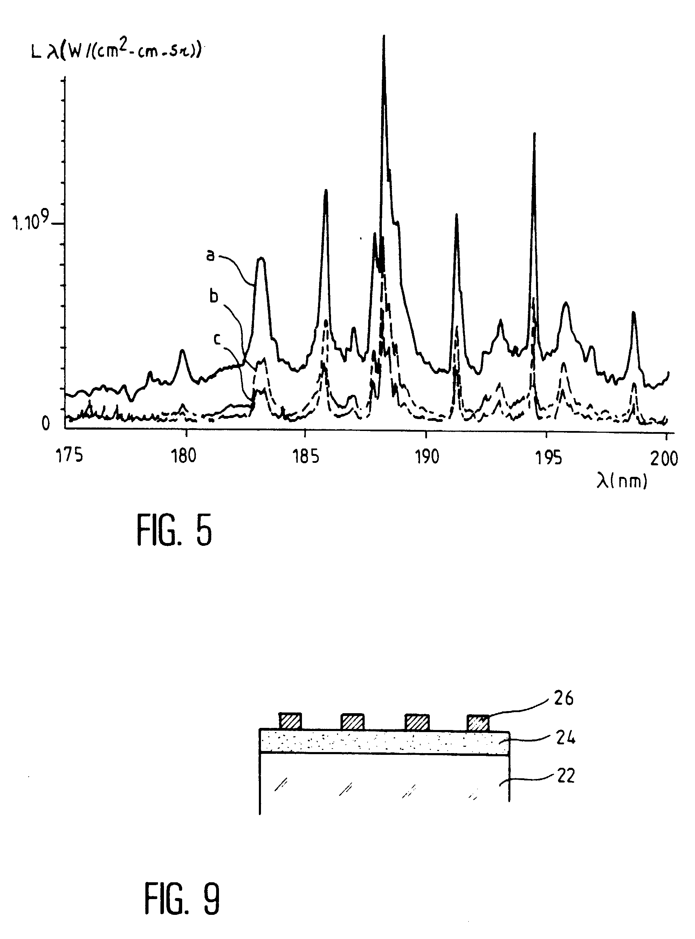

A titre illustratif, on a représenté sur la figure 5 les variations de la luminance spectrale en fonction de la longueur d'onde pour un tube rempli de krypton sous 13,3 kPa pour trois énergies de décharge. Les courbes a, b et c correspondent respectivement à des énergies de décharge de 45 J, 24 J et 16 J.

De ces courbes, il découle que plus l'énergie de charge augmente, plus l'intensité du rayonnement ultraviolet augmente.

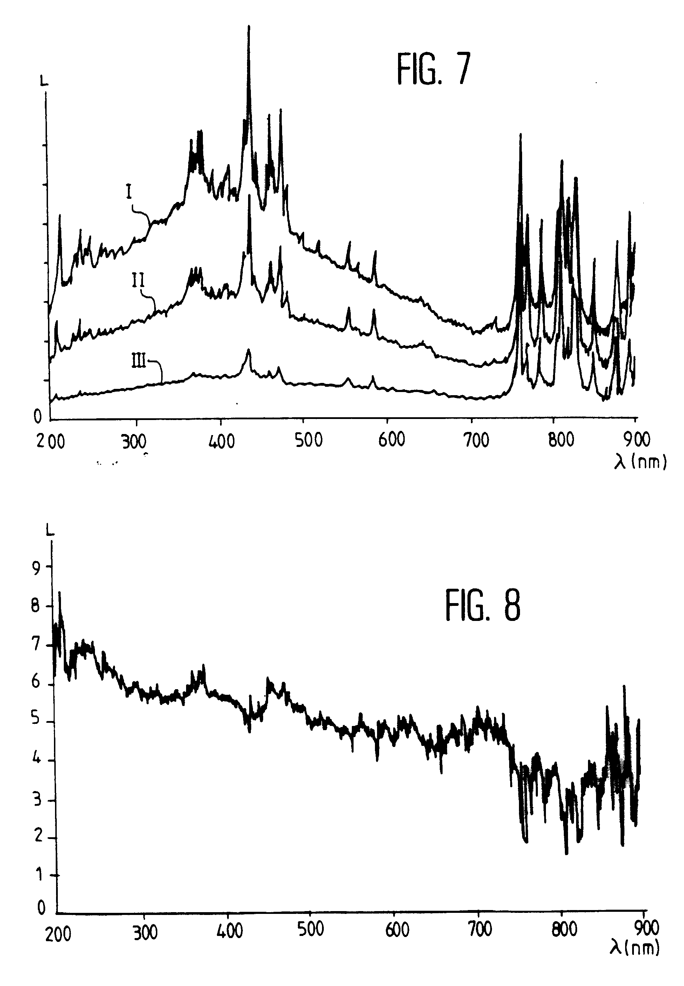

Sur la figure 6, on a représenté les variations de la luminance maximale en fonction de l'énergie de charge pour un tube contenant du krypton à 13,3 kPa, dans la gamme spectrale 175-200 nm. D'après cette courbe, on constate que la luminance croît linéairement avec l'énergie de charge.

Ainsi, la possibilité de choisir pour chaque processus photochimique envisagé, le type de gaz (répartition spectrale des raies ioniques), l'énergie électrique de la décharge (flux de photons instantané) et la fréquence des tirs permet une bonne adaptation des caractéristiques de cette lampe.

D'autre part, les essais effectués sur réacteur ont également montré que la partie du rayonnement visible et proche infrarouge émis par cette lampe apportait une amélioration sensible quant à la qualité des dépôts CVD réalisés sur un substrat.

La source lumineuse décrite ci-dessus permet donc d'allier dans une même irradiation les avantages de l'UVCVD et de la CVD par thermie rapide.

Sur la figure 7, on a représenté le spectre d'émission de la lampe utilisable dans l'invention entre 200 et 900 nm. Les spectres de la figure 7 sont ceux d'un tube contenant du krypton à 13,3 kPa. Les spectres I, II et III correspondent respectivement à une énergie de charge de 45 J, de 28,8 J, et de 12,8 J.

De ces courbes, on en déduit que l'augmentation de l'énergie de charge et donc de l'intensité de courant traversant le tube se traduit par une plus forte contribution du rayonnement dans l'ultraviolet.

La figure 8 donne le rapport des spectres I et III de la figure 7 qui confirme bien que la contribution des rayonnements ultraviolets augmente avec l'énergie de charge.

Il est important de noter que les spectres donnés précédemment ne sont qu'illustratifs et que les paramètres de la lampe peuvent être optimisés en fonction de chaque traitement photochimique et notamment en fonction des précurseurs gazeux utilisés dans les différents traitements.

La source de lumière utilisée dans l'invention se compare avantageusement avec les lampes à deutérium et présente en outre un spectre d'émission plus étendu que les sources lasers.

De plus, cette lampe émet dans l'ultraviolet avec une luminance 100 fois plus élevée que les lampes basse pression à vapeur de mercure traditionnellement utilisées dans les procédés de dépôt photo-CVD et qui émettent en général à 185 nm avec une luminance de 1,7mW/cm².sr ou à 254 nm avec une luminance de 15mW/cm².sr.

Le spectre dans la gamme spectrale (180-260nm) est une superposition d'un continuum et de raies discrètes. Il est possible de faire varier la répartition de l'énergie entre le continuum et les raies en faisant varier la pression et la nature du gaz.

A titre d'illustration, on a reporté, dans le tableau II ci-après, les valeurs de luminances maximales instantanées et moyennes à 1 Hz mesurées pour les trois tubes dans la bande spectrale 180-260nm. On a également reporté les valeurs de la luminance maximale et moyenne d'une lampe à vapeur de mercure connue, en forme de U, ayant la plus forte émission dans cette intervalle, avec les raies de résonance 185 et 254 nm.

**TABLEAU II**

| Lampe | Luminance instantanée W/(cm².sr) | Luminance moyenne mW/(cm².sr) |
|---|---|---|
| Krypton 13,3kPa | 3400 | 100 |
| Argon 13,3kPa | 1650 | 50 |
| Xénon 13,3kPa | 1400 | 42 |
| Mercure forme en U | 1,6.10⁻¹ | 9,4 |

La lampe utilisable dans l'invention émettant à partir de 160 nm permet, par rapport à ces lampes au mercure, un procédé de dépôt par photolyse directe, c'est-à-dire par irradiation directe du substrat sur lequel doit être réalisé le dépôt alors que jusqu'à ce jour, on ne pouvait effectuer qu'une photolyse indirecte faisant intervenir un gaz photosensibilisateur.

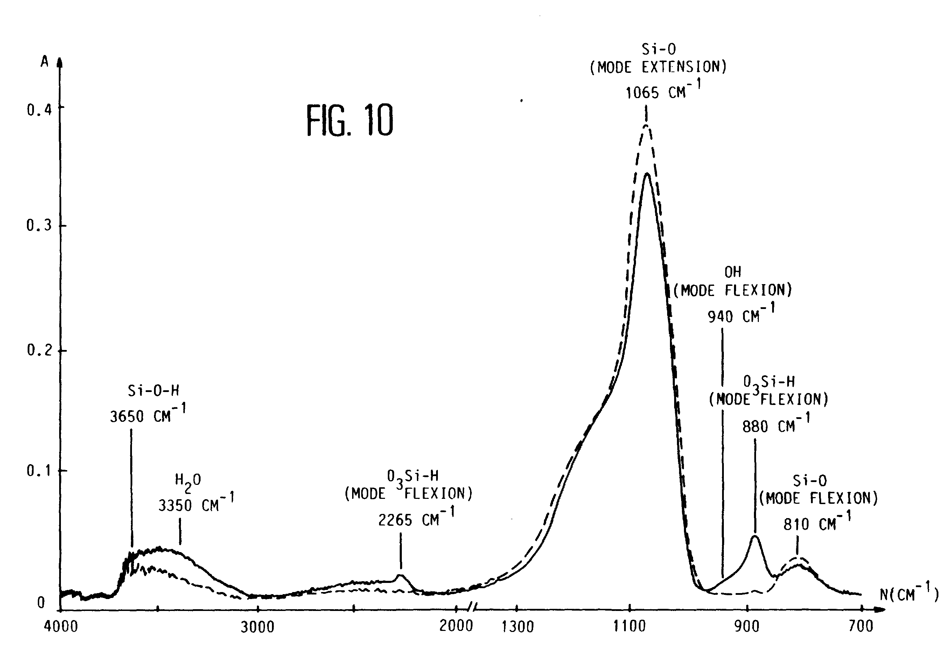

Grâce au procédé de traitement de l'invention et à la lampe décrite ci-dessus, il est maintenant possible de réaliser un condensateur du type MIS sur un substrat en InP tel que représenté sur la figure 9.

A cet effet, on introduit un substrat 22 d'InP dopé n dans un réacteur photo-CVD en silice synthétique dont la fenêtre de transmission est celle donnée à la figure 2. On nettoie le substrat 22 en le soumettant à un flux de silane et à des impulsions émises par la lampe décrite précédemment.

On dépose alors une couche 24 de SiO₂ en soumettant le substrat d'InP porté à 200°C à un mélange de silane et d'oxygène et en l'irradiant avec la source de lumière utilisable dans l'invention. On effectue ensuite un recuit de la silice en l'irradiant avec la source à éclairs, sous flux d'oxygène. On effectue alors un dépôt localisé de titane 26 en irradiant localement le substrat selon une incidence normale en présence d'un flux de TiCl₄. On répète plusieurs fois cette étape de dépôt localisé de façon à former différents plots de titane. On sort alors la plaque d'InP du réacteur.

Le recuit de la silice sous le flux d'oxygène et irradiation avec la lampe utilisable dans l'invention consiste à transformer la couche d'oxyde de silicium déposée de formule générale SiOₓH_{y} avec 0<x<2 et 0<y<4 en SiO₂ stoechiométrique. Dans ce traitement à froid, il n'y a pas fusion du matériau déposé comme dans les procédés classiques de recuit.

On donne ci-après des exemples de mise en oeuvre du procédé de l'invention.

### EXEMPLE 1

Cet exemple concerne le dépôt d'une couche de SiO₂ de 60 à 70nm d'épaisseur sur un substrat monocristallin de silicium ou d'InP. La lampe est une lampe à xénon sous une pression de 13,3kPa (100 torrs).

On donne ci-après les conditions opératoires.
- débit de silane : 10 cm³/min,
- débit d'oxygène : 100 cm³/min,
- débit d'azote (gaz porteur) : 1000 cm³/min,
- pression totale : 0,65kPa (5 torrs),
- température du substrat due à l'irradiation : 100°C,
- durée d'exposition du substrat à la lampe de l'invention : 10 min,
- fréquence des éclairs lumineux : 7 Hz.
- énergie électrique : 28,8 J,
- luminance moyenne : 7mW/cm².sr pour 1Hz
- intervalle spectral : 175-200nm,
- vitesse de dépôt : 6nm/min.

L'indice de réfraction de la couche obtenue, mesurée par ellipsométrie, est de 1,46 à la longueur d'onde 0,6µm d'un laser à hélium-néon.

### EXEMPLE 2

Cet exemple concerne le traitement à froid d'une couche de SiO₂ déposée selon l'exemple 1.

Ce traitement est effectué avec la lampe de l'exemple 1. Il permet l'obtention d'une couche de SiO₂ de qualité électronique. Ce traitement permet de réduire la quantité de liaisons SiH présentes dans la couche d'oxyde, provenant du silane. Ce traitement est effectué sous azote. Les groupements SiH, SiOH et l'eau présents dans les pores de la couche constituent les précurseurs de SiO₂.
- débit d'azote : 500 cm³/min,
- pression totale : 1,85.10²Pa (1,5 torr),
- température du substrat due à l'irradiation : 100°C,
- durée d'irradiation de la couche : 3,5 heures,
- fréquence des éclairs lumineux : 7 Hz.
- énergie électrique : 28,8 J,
- luminance moyenne : 7mW/cm².sr pour 1Hz,
- intervalle spectral : 175-200nm.

### EXEMPLE 3

Cet exemple concerne le nettoyage des hydroxyles de la surface d'une couche de silice déposée sur un substrat en InP, sous flux d'azote avec la lampe de l'exemple 1. Les groupements HO-Si-O de la couche constituent les précurseurs de SiO₂.
- épaisseur de silice : 15 nm,
- débit d'azote : 500 cm³/min,
- pression totale : 1,85.10² Pa (1,5 torr),
- température du substrat due à l'irradiation : 220°C,
- durée d'irradiation du substrat : 15 min.,
- fréquence des éclairs lumineux : 7 Hz,
- énergie électrique : 28,8 J,
- luminance moyenne : 7mW/cm².sr pour 1Hz,
- intervalle spectral : 175-200nm.

### EXEMPLE 4

Cet exemple concerne la transformation de l'oxyde natif de substrat d'InP ou de GaAs en SiO₂ stoechiométrique. Cette conversion est effectuée avec la lampe de l'exemple 1 sous un flux de silane. L'oxyde natif et le silane constituent les précurseurs de SiO₂.
- débit de silane : 20 cm³/min,
- pression totale : 1,3.10²Pa (1 torrs),
- température du substrat due à l'irradiation : 220°C,
- durée d'irradiation du substrat : 2 heures et 5 min,
- fréquence des éclairs lumineux : 25 Hz,
- énergie électrique : 28,8 J,
- luminance moyenne : 7mW/cm².sr pour 1Hz,
- intervalle spectral : 175-200nm.

### EXEMPLE 5

Une couche de SiO₂ de 600nm a été déposée sur un substrat de silicium dans les mêmes conditions que dans l'exemple 1 à l'exception de la durée du dépôt et donc de l'exposition à la lampe qui était de 100 min.

Cette couche a ensuite été traitée à froid comme dans l'exemple 2 sous azote pendant 105 min.

Les courbes d et e de la figure 10 donnent respectivement l'évolution des spectres IR à séries de Fourier (FTIR) de la couche de SiO₂ avant et après le traitement sous azote. Ces courbes donnent les variations de l'absorbance (A) en fonction du nombre d'ondes (N) exprimé en cm⁻¹. Sur ces courbes on a fait apparaître les différents groupements de la couche de SiO₂ (-Si-O-H, O₃Si-H, -Si-O, H₂O, etc.) ainsi que leur fréquence d'absorption en mode extension et en mode flexion.

En comparant ces courbes, on constate la disparition totale des liaisons Si-H après irradiation directe de la couche de SiO₂ et inversement l'augmentation des liaisons SiO.

### EXEMPLES 6 ET 7 et CONTRE-EXEMPLES

Des couches de SiO₂ de 60nm déposées par photolyse à l'aide d'une lampe à mercure basse pression continue ont été traitées comme dans l'exemple 2, sous azote. Parallèlement, des couches de SiO₂ de 60nm déposées dans les mêmes conditions ont été traitées in situ par une lampe à mercure basse pression continue.

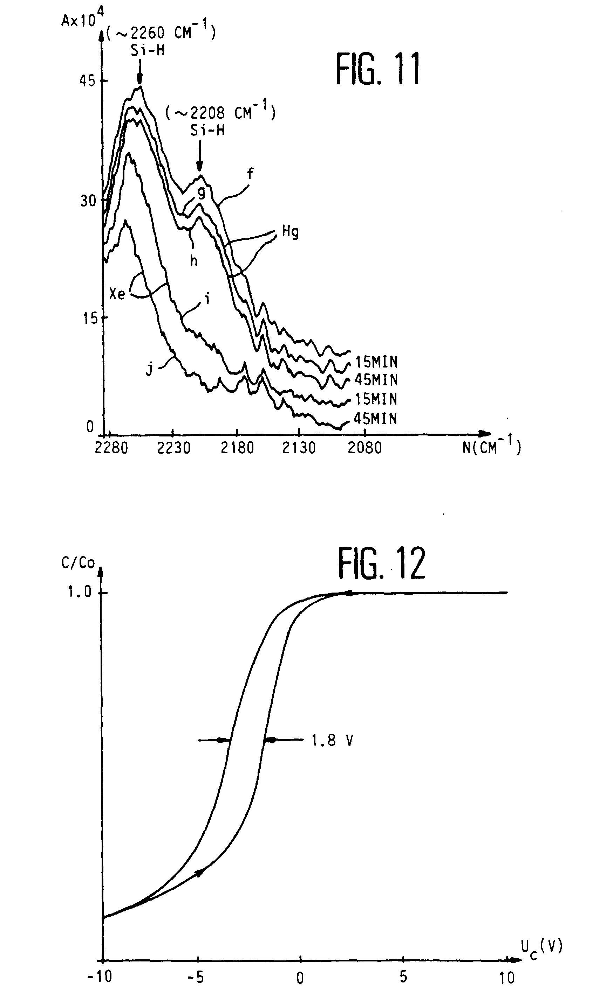

Les courbes de la figure 11 donnent l'évolution des spectres FTIR des couches de SiO₂ avant traitement puis après traitement (variations de l'absorbance A avec le nombre d'ondes N). La courbe f est relative à une couche de SiO₂ non traitée. Les courbes g et h sont relatives à des couches traitées avec la lampe à mercure pendant respectivement 15 et 45 min. Les courbes i et j (correspondant respectivement aux exemples 6 et 7) sont relatives à des couches traitées avec la lampe de l'invention pendant respectivement 15 et 45 min.

D'après ces courbes, on constate que les liaisons Si-H des couches de SiO₂ disparaissent avec le procédé de traitement de l'invention alors qu'elles subsistent avec une irradiation par lampe à mercure.

En outre, avec le procédé de l'invention, le nombre de liaison Si-H diminue avec la durée de l'irradiation.

### EXEMPLE 8

On a réalisé un condensateur en déposant une couche métallique sur une couche de SiO₂ de 60nm d'épaisseur déposée comme dans l'exemple 1 puis traitée comme dans l'exemple 2 pendant 3 heures seulement. La figure 12 donne les variations de la capacité en valeur normalisée (C/Co) du condensateur en fonction de la tension U_{c}, exprimée en volt, appliquée à ses bornes.

On constate que l'hystérésis du condensateur sur la figure 12 n'est pas trop grande (décalage de 1,8V seulement entre la charge et la décharge).

Par ailleurs, on constate que ce condensateur présente une bonne évacuation et une bonne accumulation des charges.

## Revendications

1. Procédé de traitement photochimique d'un matériau solide, consistant à exposer ce matériau à des impulsions lumineuses produites par au moins un tube allongé à gaz rare sous basse pression et à décharge luminescente dont le gaz, la pression et les caractéristiques de la décharge sont adaptés audit matériau et à ses précurseurs, chaque impulsion contenant un spectre d'émission étendu allant de 160 à 5000nm, les précurseurs consistant en des gaz, des liquides ou des solides présents dans le matériau, sur le matériau et/ou dans un flux de gaz porteur.

2. Procédé selon la revendication 1, caractérisé en ce que l'on choisit le gaz, sa pression et les caractéristiques de la lampe pour que le spectre présente des raies d'émission ionique dans l'ultraviolet, ces raies étant aptes à être absorbées par lesdits précurseurs et non par le matériau, et un continuum de spectre dans le visible et l'infrarouge.

3. Procédé selon la revendication 1 ou 2, caractérisé en ce que chaque impulsion lumineuse a une durée de 1 à 200µs et la fréquence des impulsions est choisie de 1 à 5000 Hz.

4. Procédé selon la revendication 1 , caractérisé en ce que la décharge présente une densité de courant de 1kA/cm² à 10 kA/cm².

5. Procédé selon l'une quelconque des revendications 1 à 4, de dépôt en phase vapeur d'une couche mince ou épaisse sur un substrat, caractérisé en ce qu'il consiste à soumettre le substrat à au moins un précurseur gazeux, liquide ou solide de ladite couche pendant que l'on expose le substrat auxdites impulsions lumineuses.

6. Procédé selon l'une quelconque des revendications 1 à 5, de dépôt local en phase vapeur, d'une couche mince ou épaisse sur un substrat, consistant à soumettre le substrat à au moins un précurseur gazeux, liquide ou solide de ladite couche et simultanément à exposer localement le substrat auxdites impulsions lumineuses.

7. Procédé selon la revendication 5 ou 6, caractérisé en ce que la couche est un isolant, un métal, un semi-métal ou un semi-conducteur.

8. Procédé selon l'une quelconque des revendications 5 à 7, caractérisé en ce que la couche est une couche de dioxyde de silicium et le précurseur gazeux est un mélange de silane et de protoxyde d'azote ou d'oxygène.

9. Procédé selon l'une quelconque des revendications 5 à 7, caractérisé en ce que la couche est une couche de nitrure de silicium et le précurseur gazeux est un mélange de silane et d'ammoniac.

10. Procédé selon l'une quelconque des revendications 5 à 7, caractérisé en ce que la couche est une couche d'oxynitrure de silicium et le précurseur gazeux est un mélange de silane, de protoxyde d'azote et d'ammoniac.

11. Procédé selon l'une quelconque des revendications 1 à 4 de dépôt en phase vapeur, in situ et en alternance, de couches de nature différente, consistant à
1)- soumettre le substrat à au moins un premier précurseur gazeux, liquide ou solide d'une première couche pendant que l'on expose le substrat auxdites impulsions lumineuses,
2)- soumettre le substrat à au moins un second précurseur gazeux, liquide ou solide d'une seconde couche pendant que l'on expose à nouveau le substrat auxdites impulsions lumineuse, et
3)- répéter successivement les étapes 1 et 2 jusqu'à obtenir un empilement de couches voulu.

12. Procédé selon l'une quelconque des revendications 5 à 11, caractérisé en ce que le substrat est maintenu à une température choisie dans la gamme allant de la température ambiante à 300°C, cette température résultant de l'exposition aux impulsions lumineuses.

13. Procédé selon l'une quelconque des revendications 1 à 4 de conversion d'un oxyde natif d'un matériau III-V en oxyde de silicium, caractérisé en ce qu'il consiste à soumettre le matériau III-V à du silane pendant qu'on expose le matériau auxdites impulsions lumineuses.

14. Procédé selon l'une quelconque des revendications 1 à 4, de nettoyage à froid d'un matériau semi-conducteur, isolant ou métallique, caractérisé en ce que l'on soumet le matériau maintenu à température ambiante à un gaz de nettoyage pendant qu'on l'expose auxdites impulsions.

15. Procédé selon la revendication 14, caractérisé en ce que le matériau est un semi-conducteur réalisé avec les éléments III et V du tableau périodique, du dioxyde de silicium ou du nitrure de silicium.

16. Procédé selon l'une quelconque des revendications 1 à 4, de traitement à froid d'une couche mince déposée à température ambiante, par activation photonique.

## Patentansprüche

1. Verfahren zur photochemischen Behandlung eines festen Materials, darin bestehend, dieses Material Lichtimpulsen auszusetzen, welche durch wenigstens eine längliche Röhre mit Edelgas unter niedrigem Druck und mit leuchtender Entladung erzeugt werden, deren Gas, Druck und Entladungscharakteristiken an das genannte Material und an seine Vorläufer angepaßt sind, wobei jeder Impuls ein breites, von 160 bis 5000 nm gehendes Emissionsspektrum enthält und wobei die Vorläufer aus Gasen, Flüssigkeiten oder Feststoffen bestehen, die in dem Material, auf dem Material und/oder in einem Trägergasstrom vorhanden sind.

2. Verfahren nach Anspruch 1, dadurch gekennzeichnet, daß man das Gas, seinen Druck und die Charakteristiken der Lampe wählt, damit das Spektrum ionische Emissionspeaks im Ultravioletten, wobei diese Peaks geeignet sind, durch die genannten Vorläufer und nicht durch das Material absorbiert zu werden, und ein kontinuierliches Spektrum im sichtbaren Bereich und im Infraroten aufweist.

3. Verfahren nach Anspruch 1 oder 2, dadurch gekennzeichnet, daß jeder Lichtimpuls eine Dauer von 1 bis 200 µs hat und die Frequenz der Impulse zwischen 1 bis 5000 Hz gewählt wird.

4. Verfahren nach Anspruch 1, dadurch gekennzeichnet, daß die Entladung eine Stromdichte von 1 kA/cm² bis 10 kA/cm² aufweist.

5. Verfahren nach einem der Ansprüche 1 bis 4 zur Abscheidung in der Dampfphase einer dünnen oder dicken Schicht auf einem Substrat, dadurch gekennzeichnet, daß es darin besteht, das Substrat mindestens einem gasförmigen, flüssigen oder festen Vorläufer der genannten Schicht zu unterwerfen, während man das Substrat den genannten Lichtimpulsen aussetzt.

6. Verfahren nach einem der Ansprüche 1 bis 5 zur lokalen Abscheidung in der Dampfphase einer dünnen oder dicken Schicht auf einem Substrat, darin bestehend, das Substrat wenigstens einem gasförmigen, flüssigen oder festen Vorläufer der genannten Schicht zu unterwerfen und gleichzeitig das Substrat lokal den genannten Lichtimpulsen auszusetzen.

7. Verfahren nach Anspruch 5 oder 6, dadurch gekennzeichnet, daß die Schicht ein Isolator, ein Metall, ein Halbmetall oder ein Halbleiter ist.

8. Verfahren nach einem der Ansprüche 5 bis 7, dadurch gekennzeichnet, daß die Schicht eine Siliciumdioxidschicht ist und der gasförmige Vorläufer eine Mischung von Silan und von Distickstoffoxid oder Sauerstoff ist.

9. Verfahren nach einem der Ansprüche 5 bis 7, dadurch gekennzeichnet, daß die Schicht eine Siliciumnitridschicht ist und der gasförmige Vorläufer eine Mischung von Silan und von Ammoniak ist.

10. Verfahren nach einem der Ansprüche 5 bis 7, dadurch gekennzeichnet, daß die Schicht eine Siliciumoxynitridschicht ist und der gasförmige Vorläufer eine Mischung von Silan, von Distickstoffoxid und von Ammoniak ist.

11. Verfahren nach einem der Ansprüche 1 bis 4 zur Abscheidung in der Dampfphase von Schichten verschiedener Natur, in situ und abwechselnd, darin bestehend:
1) - das Substrat wenigstens einem ersten gasförmigen, flüssigen oder festen Vorläufer einer ersten Schicht zu unterwerfen, während man das Substrat den genannten Lichtimpulsen aussetzt,
2) - das Substrat wenigstens einem zweiten gasförmigen, flüssigen oder festen Vorläufer einer zweiten Schicht zu unterwerfen, während man das Substrat erneut den genannten Lichtimpulsen aussetzt, und
3) - nacheinander die Schritte 1 und 2 zu wiederholen, bis man einen gewünschten Schichtaufbau erhalten hat.

12. Verfahren nach einem der Ansprüche 5 bis 11, dadurch gekennzeichnet, daß das Substrat auf einer Temperatur gehalten wird, die in dem von der Umgebungstemperatur bis 300°C gehenden Bereich gewählt ist, wobei diese Temperatur sich aus der Aussetzung an die Lichtimpulse ergibt.

13. Verfahren nach einem der Ansprüche 1 bis 4 zur Umwandlung eines nativen Oxids eines III-V-Materials in Siliciumoxid, dadurch gekennzeichnet, daß es darin besteht, das III-V-Material Silan zu unterwerfen, während man das Material den genannten Lichtimpulsen aussetzt.

14. Verfahren nach einem der Ansprüche 1 bis 4 zur Reinigung in der Kälte eines halbleitenden, isolierenden oder metallischen Materials, dadurch gekennzeichnet, daß man das bei Umgebungstemperatur gehaltene Material einem Reinigungsgas- unterwirft, während man es den genannten Impulsen aussetzt.

15. Verfahren nach Anspruch 14, dadurch gekennzeichnet, daß das Material ein Halbleiter ist, der mit den III- und V-Elementen des Periodensystems, Siliciumdioxid oder Siliciumnitrid hergestellt ist.

16. Verfahren nach einem der Ansprüche 1 bis 4 zur Behandlung in der Kälte einer bei Umgebungstemperatur abgeschiedenen dünnen Schicht durch Photonenaktivierung.

## Claims

1. Process for the photochemical treatment of a solid material consisting of exposing said material to light pulses produced by at least one glow discharge, elongated tube with a rare gas under low pressure and whereof the gas, pressure and characteristics of the discharge are adapted to said material and its precursors, each pulse containing an extensive emission spectrum between 160 and 5000 nm, the precursors consisting of gases, liquids or solids present in the material, on the material and/or in a carrier gas flow.

2. Process according to claim 1, characterized in that the gas, its pressure and the characteristics of the lamp are chosen so that the spectrum has ionic emission lines in the ultraviolet, said lines being absorbable by said precursors and not by the material, and a spectrum continuum in the visible and infrared.

3. Process according to claim 1 or 2, characterized in that each light pulse lasts 1 to 200 µs and the frequency of the pulses is between 1 and 5000 Hz.

4. Process according to claim 1, characterized in that the discharge has a current density from 1 to 10 kA/cm².

5. Process according to any one of the claims 1 to 4 for the vapour phase deposition of a thick or thin film on a substrate, characterized in that it consists of subjecting the substrate to the action of at least one gaseous, liquid or solid precursor of said film whilst exposing the substrate to said light pulses.

6. Process according to any one of the claims 1 to 5 for the local vapour phase deposition of a thick or thin film on a substrate, consisting of exposing the substrate to at least one gaseous, liquid or solid precursor of said film and simultaneously locally exposing the substrate to said light pulses.

7. Process according to claim 5 or 6, characterized in that the film is an insulant, a metal, a semimetal or a semiconductor.

8. Process according to any one of the claims 5 to 7, characterized in that the film is a silicon dioxide film and the gaseous precursor is a mixture of silane and oxygen or nitrogen protoxide.

9. Process according to any one of the claims 5 to 7, characterized in that the film is a silicon nitride film and the gaseous precursor is a mixture of silane and ammonia.

10. Process according to any one of the claims 5 to 7, characterized in that the film is a silicon oxynitride film and the gaseous precursor is a mixture of silane, nitrogen protoxide and ammonia.

11. Process according to any one of the claims 1 to 4 for the in situ, alternating vapour phase deposition of films having a different nature and comprising
1) subjecting the substrate to at least one first gaseous, liquid or solid precursor of a first film, whilst exposing the substrate to said light pulses,
2) subjecting the substrate to at least one second gaseous, liquid or solid precursor of a second film whilst exposing the substrate once again to said light pulses and
3) successively repeating stages 1 and 2 until a desired film stack is obtained.

12. Process according to any one of the claims 5 to 11, characterized in that the substrate is kept at a temperature chosen from within the range extending from ambient temperature to 300°C, said temperature resulting from the exposure to the light pulses.

13. Process according to any one of the claims 1 to 4 for the conversion of a native oxide of a III-V material into silicon oxide, characterized in that it consists of subjecting the III-V material to silane whilst exposing the material to said light pulses.

14. Process according to any one of the claims 1 to 4 for the cold cleaning of a semiconductor, insulating or metallic material, characterized in that the material, maintained at ambient temperature, is exposed to the action of a cleaning gas, whilst exposing it to the said pulses.

15. Process according to claim 14, characterized in that the material is a semiconductor produced with III and V elements of the periodic table, silicon dioxide or silicon nitride.

16. Process according to any one of the claims 1 to 4 for the cold treatment of a thin film deposited at ambient temperature by photon activation.
